# EUROPEAN PATENT SPECIFICATION

(11) **EP 2 839 515 B1**
(45) Date of publication and mention of the grant of the patent: **08.06.2016**
(21) Application number: 13717042.9
(22) Date of filing: 18.04.2013
(51) Int. Cl.: H01L 31/052, H01L 31/048

(54) **FIELD-ASSEMBLABLE CONCENTRATION PHOTOVOLTAICS SYSTEM**
FOTOVOLTAISCHES SYSTEM MIT FELDKONZENTRATION
SYSTÈME PHOTOVOLTAÏQUE À CONCENTRATION ASSEMBLABLE SUR PLACE

(30) Priority: 18.04.2012 US 201261625693 P
(43) Date of publication of application: 25.02.2015
(73) Proprietor: Pardell Vilella, Ricard, 08197 Valldoreix (ES)
(72) Inventor: Pardell Vilella, Ricard, 08197 Valldoreix (ES)
(74) Representative: Mohammadian, Dario
(86) International application number: PCT/EP2013/058049
(87) International publication number: WO 2013/156549

(56) References cited:
- EP-A1- 1 895 597
- WO-A2-2009/148840
- US-A- 6 020 554
- US-A1- 2009 260 674
- US-A1- 2011 203 638

## Description

### TECHNICAL FIELD

The present invention relates generally to the assembly of concentration photovoltaic CPV systems, and in particular to a CPV assembly system that facilitates pre-assembly storage and transport as well as allows field-assembly of the CPV system.

### BACKGROUND OF THE INVENTION

Concentration photovoltaic CPV technology uses optics such as lenses or curved mirrors to concentrate a large amount of sunlight onto a small area of solar photovoltaic PV cells to generate electricity. CPV systems usually comprise a plurality of primary optical elements POE that concentrate incoming light onto a plurality of CPV receivers. One common kind of CPV systems is based on the combination of primary refractive optics with CPV receivers arranged in a matrix pattern.

The optics and receivers must be protected from the environment and therefore the ensemble constitutes a shape similar to a box, its depth being basically determined by the primary optics focal length and its width and length determined by each primary optics dimensions and by the number of receivers arranged in each dimension. Therefore the assembly of such systems requires high technological installation sites to guarantee the tight tolerance requirements of CPV systems.

The volume filled by a refractive CPV module is therefore proportional to the primary optics focal length. Given a specific concentration ratio (solar aperture to cell area ratio) and a primary optics F number (focal length to aperture ratio), the focal length and therefore the depth of the module is proportional to the cell size, and so the volume of the module. As a consequence, the volume of CPV modules is a function of cell size, concentration ratio and primary optics F number. The volume of CPV systems having medium to large CPV cells (4 mm side or more) is therefore significantly large.

This significant volume poses a logistic problem. Storing and transporting through long distances large volumes of air is not efficient. The larger the cells the larger this problem becomes, reducing CPV advantages in front of flat photovoltaic PV panels. Some CPV manufacturers have decided to use very small CPV cells (in the order of 1 mm side) in order to alleviate this problem. This can increase the cost due to the multiplication of CPV receivers per power unit it implies.

Therefore a need has been identified to provide a CPV system that combines larger cells in such a way that it is possible to ship the components to a low technology installation site and to assemble them on field, while avoiding the logistics problem associated with the transport of CPV cells. In order to fulfill this need, the tight mounting tolerances and environmental protection requirements of CPV systems have to be obeyed. Also, the modules have to allow an assembly process that respects all the geometrical requirements of the optical system.

Patent publication US6020554A discloses a solar concentrator designed to be assembled in the field, wherein the individual components (heat-sink, Fresnel lens, side walls) are held together using mechanical clips and therefore can be assembled on the field. However, it only has a flat frame section (flat reflectors) and the optics and the receiving section are not easily stacked. Therefore, the components do not allow an efficient packing during transport nor an accurate assembly in the field.

### SUMMARY

It is therefore an object of the present invention to provide solutions to the above mentioned problems. In accordance with one or more embodiments and corresponding disclosure thereof, various aspects are described in connection with providing a CPV assembly system that allows on-field assembly, space-efficient storage and optimized shipment, all in a repetitive manner.

In a preferred embodiment of the invention a concentration photovoltaic CPV assembly system is provided which occupies little space during storage and facilitates its transport due to the flat structure of its components as well as facilitates field assembly into a rigid structure with tight mounting tolerances.

### BRIEF DESCRIPTION OF THE DRAWING(S)

The features and advantages of the present invention become more apparent from the detailed description set forth below when taken in conjunction with the drawings in which like reference characters identify corresponding elements in the different drawings. Corresponding elements may also be referenced using different characters.
FIG. 1 is a general overview of the assembled CPV assembly system of the invention.
FIG. 2 is an exploded view of the CPV assembly system of the invention.
FIG. 3 is a detailed view of mounting brackets fixing means on the optics panel of the CPV assembly system of the invention.
FIG. 4 is a diagonal view of the frame section of the CPV assembly system of the invention.
FIG. 5 is a cross-sectional view of one corner of the assembled CPV assembly system of the invention.

### DETAILED DESCRIPTION OF THE INVENTION

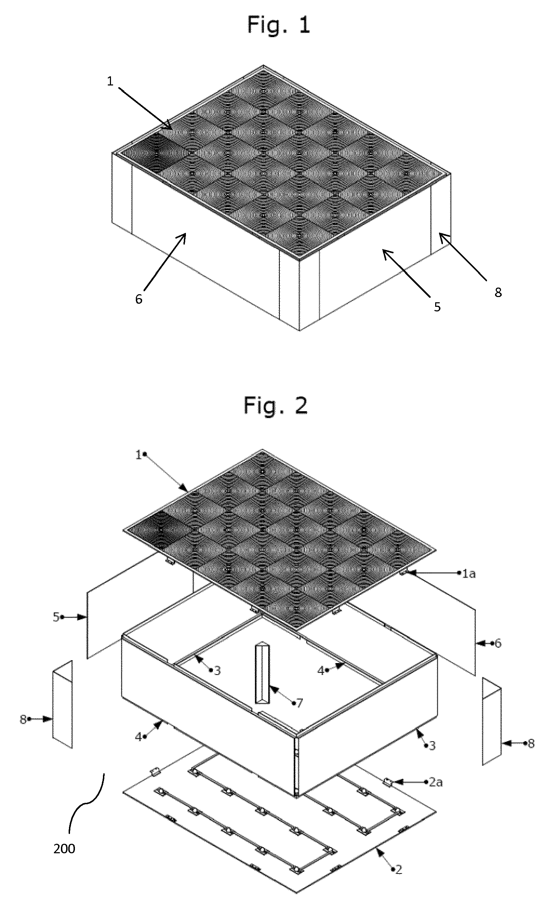

FIG. 1 is a general overview of an assembled CPV assembly system according to one embodiment of the present invention. It should be noted that in its mounted state the CPV assembly system comprises mostly air thereby posing a transport problem if transported to the installation site as a ready-made assembled system.

FIG. 2 is an exploded view of the CPV assembly system 200. The CPV assembly system 200 comprises a upper primary optical section 1 (primary optics panel), an lower photovoltaic receiving section 2 (receiver panel), a frame section 9 (side walls), and fixing means for assembling the upper, lower and frame sections together enabling sun light to be concentrated by the upper primary optical section in between the frame section onto the lower photovoltaic receiving section. These plurality of sections are substantially flat enabling minimizing the space occupied when unassembled and the CPV system transport.

As can be seen the upper primary optical section comprises at least one primary refractive optic, the lower photovoltaic receiving section comprises at least one CPV receiver, and the upper and lower sections are parallel with respect to each other. The frame section 9 comprises an internal section and an external section. The internal section comprises four opposing internal walls. The external section comprises four opposing external walls. Once the internal and external walls are assembled together they form a frame on which the upper and lower sections can subsequently be mounted.

In other words, the CPV assembly system 200 comprises a primary optics panel including a plurality of mounting brackets 1a, a receiver panel including mounting brackets 2a, short and long internal walls 3 and 4, short and long external walls 5 and 6, internal corners 7 and external corners 8. It should be noted, that the components comprised by the CPV assembly system 200 are basically flat, and can therefore be packed and shipped efficiently as a kit, in order to assemble them near the installation site requiring facilities and tools requiring a minimal capital investment.

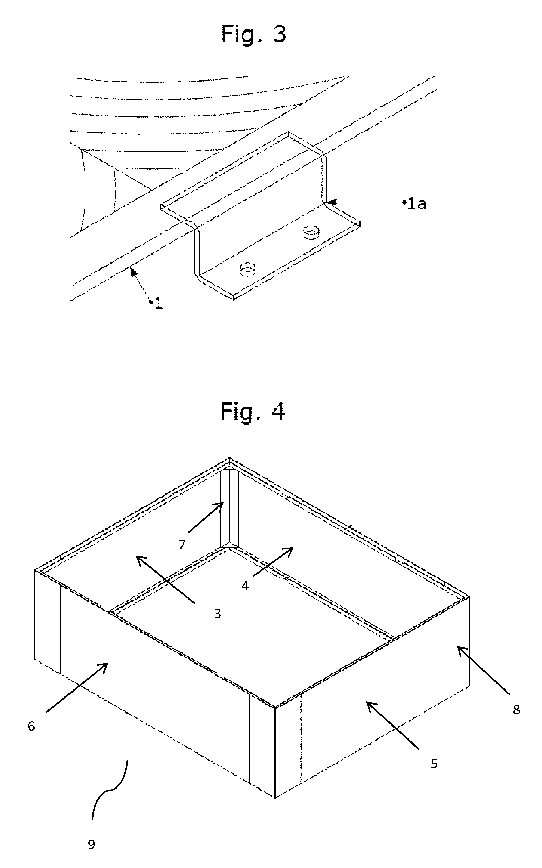

FIG. 3 is a detailed view of the assembly of the mounting brackets on the optics panel comprised in the CPV assembly system. Brackets 1a and 2a (not shown), including mounting holes, are glued to glass or plastic primary optics panel 1 using a very tight tolerance positioning method. In a preferred embodiment of the invention, these brackets are made of stainless steel or a similar material and are glued using pressure sensitive or UV curing acrylic adhesive.

FIG. 4 is an upper view of the CPV assembly system of the present invention showing the frame section 9 comprising the assembled internal and external frame walls. It should be noted that the structural members and walls are riveted together using premade holes, thereby obtaining a module assembly frame. The formation of this frame provides structural stability to the CPV assembly system. Subsequently, primary optics panels 1 and receiver panels 2 are fastened to this frame by means of mounting brackets 1a and 2a.

Consequently, if the components have been manufactured using high tech machinery and obey the most strict quality assurance procedures the CPV assembly system provides a reference system in order to mount the CPV assembly system on, or close to, the installation site whilst respecting all the geometrical requirements of the optical system, thereby allowing a correct operation of the module.

In a preferred embodiment of the invention, frame section 9 is painted with epoxy powder using an electrostatic deposition method or any alternative painting method. This paint cover improves metal part protection and covers any joint spaces left between the metal sheet parts in order to assure a high IP protection of the CPV assembly system.

In an alternative embodiment of the invention, already surface treated or pre-painted external metal sheet parts 5, 6 and 8 are used in conjunction with watertight rivets for any external joints, thereby eliminating the need of any painting equipment in the assembly workshop.

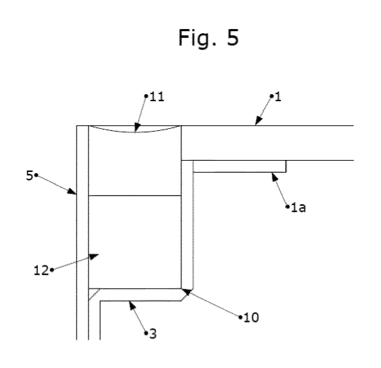

FIG. 5 is a cross-sectional view of the of the CPV assembly system. It can be observed that the components of the CPV assembly system are designed such that a channel 10 is formed between primary optics 1 and receiver panels 2 and frame 9.

In a preferred embodiment of the invention, channel 10 is filled with sealing silicone, sealing polyurethane or any other similar room temperature vulcanizing sealing material, making a continuous sealing joint 11. In anlther preferred embodiment a joint base 12 made from extruded PE foam or similar flexible material is inserted in the lower part of the channel before applying the sealing agent. This arrangement allows to reach the higher possible environmental protection for the assembled module, while posing no challenge to the mounting process of the module.

Those skilled in the art should appreciate that the foregoing discussion of one or more embodiments does not limit the present invention, nor do the accompanying figures. Rather, the present invention is limited only by the following claims:

## Claims

1. A concentration photovoltaic CPV assembly system (200) comprising:
an upper primary optical section (1) comprising a primary optics panel;
a lower photovoltaic receiving section (2);
a frame section (9) comprising an internal section and an external section, wherein the internal section comprises four internal frame walls (3, 4) and the external section comprises four external frame walls (5, 6), said frame walls comprising premade holes for the assembly of the system (200); and
fixing means (1a, 2a, 7, 8) for assembling the upper, lower and frame sections (1, 2, 9) together, wherein the fixing means comprises a first plurality of brackets (1a) mounted on the upper primary optical section (1) enabling the assembly of the upper primary optical section (1) to the upper part of the frame section (9), the brackets (1a) being positioned based on primary optic reference points; and a second plurality of brackets (2a) mounted on the lower photovoltaic receiving section (2) enabling its assembly to the lower part of the frame section (9); and
wherein the plurality of sections (1, 2, 9) are substantially flat and the fixing means (1a, 2a, 7, 8) enable assembling the plurality of sections (1, 2, 9) together permitting the sun light to be concentrated by the upper primary optical section (1) in between the frame section (9) onto the lower photovoltaic receiving section (2).

2. The CPV assembly system of claim 1, wherein the upper primary optical section (1) comprises at least one primary refractive optic, the lower photovoltaic receiving section (2) comprises at least one CPV receiver, and the upper and lower sections (1,2) are parallel with respect to each other.

3. The CPV assembly system of claim 2, wherein the height of the frame section (9) is at least that of the focal length of the at least one primary refractive optic.

4. The CPV assembly system of claim 1, wherein the fixing means comprises watertight rivets for fastening the external walls (5, 6).

5. The CPV assembly system of claim 1, wherein a channel (10) is formed at the upper and lower portions of the frame section (9) as the internal and external sections are assembled together thereby enabling a continuous watertight seal (11) by filling with a sealing material such as sealing silicone and/or sealing polyurethane and/or other vulcanizing sealing material.

6. The CPV assembly system of claim 5, wherein a base (12) is inserted in the lower part of the channel (10) before applying the sealing material.

7. The CPV assembly system of claim 1, wherein the fixing means further comprises an internal reinforcing means (7) for assembling the internal walls (3, 4) together.

8. The CPV assembly system of claim 4, wherein the fixing means further comprises an external reinforcing means (8) for assembling the external walls (5, 6) together.

9. The CPV assembly system of claim 1, wherein the first and the second plurality of brackets (1a, 2a) are made of a stainless steel material and are glued using pressure sensitive and/or curing acrylic adhesive.

10. The CPV assembly system of claim 2, wherein the lower photovoltaic receiving section (2) is painted at least on its backside, the frame section (9) is painted with epoxy powder, the external walls (5, 6) are surface treated and/or pre-painted.

11. The CPV assembly system of claim 2, wherein the lower photovoltaic receiving section (2) and the walls (3, 4, 5, 6) are computer numerically controlled, CNC, punched and/or laser cut.

12. A method for assembling a concentration photovoltaic CPV assembly system (200) comprising an upper primary optical section (1) comprising a primary optics panel, a lower photovoltaic receiving section (2), a frame section (9) comprising an internal section and an external section, wherein the internal section comprises internal frame walls (3, 4) and the external section comprises external frame walls (5, 6), said frame walls comprising premade holes for the assembly of the system (200), and fixing means (1a, 2a, 7, 8) for assembling the upper, lower and frame sections (1, 2, 9) together, wherein the plurality of sections (1, 2, 9) are substantially flat, the method comprising :
positioning a fixing means (1a) onto the upper primary optical section (1) based on primary optic reference points;
assembling the upper primary optical section (1) to the upper part of the frame section (9) using said fixing means (1a) positioned onto the upper primary optical section (1) wherein said fixing means (1a) comprise a first plurality of brackets (1a);
and assembling the lower photovoltaic receiving section (2) to the lower part of the frame section (9) using a second plurality of brackets (2a) mounted on the lower photovoltaic receiving section (2). in such a manner enabling assembling the plurality of sections (1, 2, 9) together permitting the sun light to be concentrated by the upper primary optical section (1) in between the frame section (9) onto the lower photovoltaic receiving section (2).

## Patentansprüche

1. Ein Montagesystem (200) für eine Konzentrator-Fotovoltaikanlage (CPV), umfassend
einen oberen primären optischen Abschnitt (1), der eine primäre optische Platte umfaßt;
einem unteren Fotovoltaik-Empfängerabschnitt (2);
einem Rahmenabschnitt (9), umfassend einen inneren und einem äußeren Abschnitt, wobei der innere Abschnitt vier innere Rahmenwände (3, 4) und der äußere Abschnitt vier äußere Rahmenwände (5, 6) besitzt und diese Rahmenwände zur Montage des Systems (200) vorgefertigte Löcher umfassen; und
Befestigungsmittel (1a, 2a, 7, 8) zum Zusammenbau des unteren, oberen und Rahmenabschnitts (1, 2, 9), wobei die Befestigungsmittel eine erste Vielzahl von Halterungen (1a), die auf dem oberen primären optischen Abschnitt (1) montiert sind und dessen Montage am oberen Teil des Rahmenabschnitts (9) ermöglichen, wobei die Halterungen (1a) anhand primärer optischer Referenzpunkte angeordnet sind; und eine zweite Vielzahl von Halterungen (2a), die am unteren Fotovoltaik-Empfängerabschnitt (2) montiert sind und dessen Montage am unteren Teil des Rahmenabschnitts (9) ermöglichen, umfassen; und
wobei die Vielzahl von Abschnitten (1, 2, 9) im Wesentlichen flach sind und die Befestigungsmittel (1a, 2a, 7, 8) den Zusammenbau der Vielzahl von Abschnitte (1, 2, 9) ermöglichen, wodurch die Konzentration des Sonnenlichts durch den oberen primären optischen Abschnitt (1) zwischen dem Rahmenabschnitt (9) auf den unteren Fotovoltaik-Empfängerabschnitt (2) ermöglicht wird.

2. Das Montagesystem für eine Konzentrator-Fotovoltaikanlage (CPV) gemäß Anspruch 1, wobei der obere erste optische Abschnitt (1) mindestens eine primäre Brechungsoptik umfasst, der untere Fotovoltaik-Empfängerabschnitt (2) mindestens einen CPV-Empfänger umfasst und die oberen und unteren Abschnitte (1, 2) zueinander parallel sind.

3. Das Montagesystem für eine Konzentrator-Fotovoltaikanlage (CPV) gemäß Anspruch 2, wobei die Höhe des Rahmenabschnitts (9) mindestens die der Brennweite der mindestens einer primären Brechungsoptik ist.

4. Das Montagesystem für eine Konzentrator-Fotovoltaikanlage (CPV) gemäß Anspruch 1, wobei die Befestigungsmittel wasserdichte Nieten zur Befestigung der Außenwände (5, 6) umfassen.

5. Das Montagesystem für eine Konzentrator-Fotovoltaikanlage (CPV) gemäß Anspruch 1, wobei sich beim Zusammensetzen des inneren und äußeren Abschnitts am oberen und unteren Rahmenabschnitt (9) ein Kanal (10) bildet, der eine durchgehende wasserdichte Dichtung (11) ermöglicht, indem ein Dichtungsmaterial wie dichtendes Silikon und/oder dichtendes Polyurethan und/oder ein anderes vulkanisierendes Dichtmaterial eingefüllt wird.

6. Das Montagesystem für eine Konzentrator-Fotovoltaikanlage (CPV) gemäß Anspruch 5, wobei ein Boden (12) in den unteren Teil des Kanals (10) eingesetzt wird, bevor das Dichtmaterial aufgebracht wird.

7. Das Montagesystem für eine Konzentrator-Fotovoltaikanlage (CPV) gemäß Anspruch 1, wobei die Befestigungsmittel zur gemeinsamen Montage der Innenwände (3, 4) weiter innere Verstärkungsmittel (7) umfassen.

8. Das Montagesystem für eine Konzentrator-Fotovoltaikanlage (CPV) gemäß Anspruch 4, wobei die Befestigungsmittel zur gemeinsamen Montage der Außenwände (5, 6) weiter äußere Verstärkungsmittel (8) umfassen.

9. Das Montagesystem für eine Konzentrator-Fotovoltaikanlage (CPV) gemäß Anspruch 1, wobei die erste und zweite Vielzahl von Halterungen (1a, 2a) aus rostfreiem Edelstahlmaterial sind und mit druckempfindlichem und/oder härtendem Acrylkleber verklebt sind.

10. Das Montagesystem für eine Konzentrator-Fotovoltaikanlage (CPV) gemäß Anspruch 2, wobei der untere Fotovoltaik-Empfängerabschnitt (2) zumindest an seiner Rückseite angestrichen ist, der Rahmenabschnitt (9) mit Epoxidpulver angestrichen ist, und die Außenwände (5, 6) oberflächenbehandelt und/oder vorangestrichen sind.

11. Das Montagesystem für eine Konzentrator-Fotovoltaikanlage (CPV) gemäß Anspruch 2, wobei der untere Fotovoltaik-Empfängerabschnitt (2) und die Wände (3, 4, 5, 6) per Computer numerisch gesteuert, mit einer CNC-Maschine bearbeitet, gestanzt und/oder mit Laser geschnitten sind.

12. Ein Verfahren für den Zusammenbau eines Montagesystems (200) für eine Konzentrator-Fotovoltaikanlage (CPV) umfassend einen oberen primären optischen Abschnitt (1), der eine primäre optische Platte umfaßt, einen unteren Fotovoltaik-Empfängerabschnitt (2), einen Rahmenabschnitt (9), der einen inneren und einen äußeren Abschnitt umfaßt, wobei der innere Abschnitt innere Rahmenwände (3, 4) umfaßt, und der äußere Abschnitt äußere Rahmenwände (5, 6) umfaßt, wobei besagte Rahmenwände zum Zusammenbau des Systems (200) vorgefertigte Löcher umfassen, und Befestigungsmittel (1a, 2a, 7, 8) zur gemeinsamen Montage des unteren, oberen und Rahmenabschnitts (1, 2, 9), wobei die Vielzahl der Abschnitte (1, 2, 9) im Wesentlichen flach sind, wobei das Verfahren umfasst:
die Anordnung eines Befestigungsmittels (1a) am oberen primären optischen Abschnitt (1) anhand primärer optischer Referenzpunkte;
die Montage des oberen primären optischen Abschnitts (1) am oberen Rahmenabschnitt (9) mithilfe der genannten Befestigungsmittel (1a), die auf dem oberen primären optischen Abschnitt (1) positioniert sind, wobei die besagten Befestigungsmittel (1a) eine erste Vielzahl von Halterungen (1) umfassen;
und die Montage des unteren Fotovoltaik-Empfängerabschnitts (2) am unteren Teil des Rahmenabschnitts (9) mithilfe einer zweiten Vielzahl von Halterungen (2a), die an dem unteren Fotovoltaik-Empfängerabschnitt (2) montiert ist,
derart, dass der Zusammenbau der Vielzahl von Abschnitte (1, 2, 9) ermöglicht wird, wodurch die Konzentration des Sonnenlichts durch den oberen primären optischen Abschnitt (1) zwischen dem Rahmenabschnitt (9) auf den unteren Fotovoltaik-Empfängerabschnitt (2) ermöglicht wird.

## Revendications

1. Un système d'assemblage photovoltaïque à concentration CPV (200) comprenant:
une section optique principale supérieure (1) comprenant un panneau d'optiques principal;
une section de réception photovoltaïque inférieure (2);
une section de cadre (9) comprenant une section interne et une section externe, dans laquelle la section interne comprend quatre parois de cadre interne (3, 4) et la section externe comprend quatre parois de cadre externe (5, 6), lesdites parois de cadre comprenant des trous pré-ménagés pour l'assemblage du système (200); et
des moyens de fixation (1a, 2a, 7, 8) destinés à assembler les sections supérieure, inférieure et de cadre (1, 2, 9) ensemble, où les moyens de fixation comprennent une première pluralité de supports (1a) montés sur la section optique principale supérieure (1) permettant l'assemblage de la section optique principale supérieure (1) à la partie supérieure de la section de cadre (9), les supports (1a) étant positionnés sur la base de points de référence optiques principaux; et une deuxième pluralité de supports (2a) montés sur la section de réception photovoltaïque inférieure (2) permettant son assemblage à la partie inférieure de la section de cadre (9); et
dans lequel la pluralité de sections (1, 2, 9) est sensiblement plate et les moyens de fixation (1a, 2a, 7, 8) permettent l'assemblage de la pluralité de sections (1, 2, 9) ensemble, ce qui permet à la lumière du soleil d'être concentrée par la section optique principale supérieure (1) au sein de la section de cadre (9) sur la section de réception photovoltaïque inférieure (2).

2. Le système d'assemblage CPV de la revendication 1, dans lequel la section optique principale supérieure (1) comprend au moins une optique réfractive principale, la section de réception photovoltaïque inférieure (2) comprend au moins un récepteur CPV et les sections supérieure et inférieure (1, 2) sont parallèles l'une par rapport à l'autre.

3. Le système d'assemblage CPV de la revendication 2, dans lequel la hauteur de la section de cadre (9) est au moins celle de la longueur focale de l'au moins une optique réfractive principale.

4. Le système d'assemblage CPV de la revendication 1, dans lequel les moyens de fixation comprennent des rivets étanches à l'eau pour la fixation des parois externes (5, 6).

5. Le système d'assemblage CPV de la revendication 1, dans lequel un canal (10) est formé au niveau des parties supérieure et inférieure de la section de cadre (9) lorsque les sections interne et externe sont assemblées ensemble, permettant ainsi un joint étanche à l'eau continu (11) par remplissage avec un matériau d'étanchéité tel que de la silicone d'étanchéité et/ou du polyuréthanne d'étanchéité et/ou un autre matériau d'étanchéité par vulcanisation.

6. Le système d'assemblage CPV de la revendication 5, dans lequel une base (12) est insérée dans la partie inférieure du canal (10) avant l'application du matériau d'étanchéité.

7. Le système d'assemblage CPV de la revendication 1, dans lequel les moyens de fixation comprennent en outre un moyen de renfort interne (7) pour l'assemblage des parois internes (3, 4) ensemble.

8. Le système d'assemblage CPV de la revendication 4, dans lequel les moyens de fixation comprennent en outre un moyen de renfort externe (8) pour l'assemblage des parois externes (5, 6) ensemble.

9. Le système d'assemblage CPV de la revendication 1, dans lequel la première et la deuxième pluralité de supports (1a, 2a) sont faites d'un matériau en acier inoxydable et sont collées en utilisant un adhésif acrylique à durcissement et/ou sensible à la pression.

10. Le système d'assemblage CPV de la revendication 2, dans lequel la section de réception photovoltaïque inférieure (2) est peinte au moins sur son côté arrière, la section de cadre (9) est peinte avec une poudre d'époxy, les parois externes (5, 6) sont traitées en surface et/ou pré-peintes.

11. Le système d'assemblage CPV de la revendication 2, dans lequel la section de réception photovoltaïque inférieure (2) et les parois (3, 4, 5, 6) sont contrôlées par voie numérique par ordinateur, CNC, poinçonnées et/ou découpées au laser.

12. Un procédé pour assembler un système d'assemblage photovoltaïque à concentration CPV (200) comprenant une section optique principale supérieure (1) comprenant un panneau d'optique principal, une section de réception photovoltaïque inférieure (2), une section de cadre (9) comprenant une section interne et une section externe, dans laquelle la section interne comprend des parois de cadre interne (3, 4) et la section externe comprend des parois de cadre externe (5, 6), lesdites parois de cadre comprenant des trous pré-ménagés pour l'assemblage du système (200) et des moyens de fixation (1a, 2a, 7, 8) pour assembler les sections supérieure, inférieure et de cadre (1, 2, 9) ensemble, où la pluralité de sections (1, 2, 9) est sensiblement plate, le procédé comprenant: le positionnement d'un moyen de fixation (1a) sur la section optique principale supérieure (1) sur la base de points de référence d'optique principaux; l'assemblage de la section optique principale supérieure (1) à la partie supérieure de la section de cadre (9) en utilisant ledit moyen de fixation (1a) positionné sur la section optique principale supérieure (1), dans lequel ledit moyen de fixation (1a) comprend une première pluralité de supports (1a); et l'assemblage de la section de réception photovoltaïque inférieure (2) à la partie inférieure de la section de cadre (9) en utilisant une deuxième pluralité de supports (2a) montés sur la section de réception photovoltaïque inférieure (2) d'une manière à permettre l'assemblage de la pluralité de sections (1, 2, 9) ensemble, ce qui permet à la lumière du soleil d'être concentrée par la section optique principale supérieure (1) au sein de la section de cadre (9) sur la section de réception photovoltaïque inférieure (2).
